# EUROPEAN PATENT APPLICATION

(11) **EP 3 496 102 A1**
(43) Date of publication of application: **12.06.2019**
(21) Application number: 18211429.8
(22) Date of filing: 10.12.2018
(51) Int. Cl.: G11C 11/16, G11C 11/00, G11C 17/16

(54) **METHOD AND APPARATUS FOR USING REFERENCE RESISTOR IN ONE-TIME PROGRAMMABLE MEMORY OF AN ARTIFICIAL INTELLIGENCE INTEGRATED CIRCUIT**

(30) Priority: 11.12.2017 US 201715838131
(71) Applicant: Gyrfalcon Technology Inc., Milpitas, CA 95035 (US)
(72) Inventor: TORNG, Chyu-Jiuh, Dublin, CA California 94568 (US); LIU, Daniel H., San Jose, CA California 95131 (US)
(74) Representative: Boult Wade Tennant LLP

(57) **Abstract**

An integrated circuit may include an AI logic circuit, and an embedded one-time programmable (OTP) MRAM memory electrically coupled to the AI logic circuit. The embedded OTP MRAM memory may include multiple storage cells, one or more reference resistors, and a memory-reading circuit for determining the state of each storage cell. The reading circuit may include: a multiplexer configured to electrically couple each storage cell to a reference resistor; a source line selectively providing an input electrical signal to each storage cell to generate a first output signal; a driving circuit providing an input electrical signal to the reference resistor to generate a second output signal; and a comparator configured to compare the first output signal and the second output signal to generate an output signal that indicates the state of each storage cell. Each reference resistor may be shared among multiple storages in an array or multiple storage arrays.

## Description

### BACKGROUND

This patent document relates generally to reading memory cells in an integrated circuit, and in particular to reading memory cells in one-time programmable (OTP) magnetoresistive random access memory (MRAM) memory in an artificial intelligence chip.

Memory is an important component in an artificial intelligence (AI) chip that has low power and high-performance characteristics as each AI engine is usually comprised of multiple memory components. Typical reading of data in a memory, such as a MRAM memory, uses built-in reference cells which have known states (e.g., a value of one or zero). A memory generally includes multiple storage cells, each having a state corresponding to a logical value of one or zero. In reading each storage cell, reference cells are used to ensure sensing margin due to process voltage temperature (PVT) change such that the stored information of 0 and 1 can be sensed well. In particular, the reading process will compare the measured resistances of the storage cells and those of the reference cells to decide whether each of the storage cells has a state corresponding to a logical value of '1' or '0.' For example, Na, et al. describe three types of reference cells/units in a spin transfer torque (STT)-RAM architecture: reference column, reference row and reference array. See Na, Kim, Kim, Kang and Jung, "Reference-Scheme Study and Novel Reference Scheme for Deep Submicrometer STT-RAM," IEEE Transactions on Circuits and Systems, Vol. 61, No. 12, December 2014.

In the instance of MRAM memory, each storage cell includes a single magnetic tunnel junction (MTJ) element, referred to as a MTJ bit cell. An MTJ bit cell typically has a low sense margin. The sense margin of a storage cell can be determined by the difference between the measured resistance value of the storage cell when storing a value of one and the measured resistance value of the storage cell when storing a value of zero. For example, when an MTJ bit cell with dR/R = 100% stores a value of zero, a measured corresponding low resistance value Rp may be at about 1.6 Kohms; whereas when the MTJ bit cell stores a value of one, the measured corresponding high resistance value Rap may be around 3.2Kohms. While an MTJ bit cell is usually electrically coupled to a CMOS transistor having a resistance value Rc, for example, at about 1.6Kohms, the read margin window can be calculated as (Rp+Rc) to (Rap+Rc), which is 3.2Kohms - 4.8Kohms. This read margin window is considered narrow due to PVT.

In order for each MTJ bit cell to be sensed well due to bit cell uniformity, reference cells are required to be placed as close as possible to the storage cells for which the reference cells are used due to PVT. Further, the reference cells are often built just like storage cells to maintain uniformity. For example, U.S. Patent No. 9,281,039 to Jung, et al. describe a reference cell that has four MTJ bit cells, of which two MTJ bit cells are programmed to have a value of one, and two other MTJ bit cells are programmed to have a value of zero. Each MTJ bit cell in the reference cells is also electrically coupled to a transistor, in a similar structure as that of an MTJ bit cell in storage cells. In another example, Lee, et al. describe a reference cell that includes a pair of MTJ bit cells, with one having high resistance (storing the value of one) and one having low resistance (storing the value of zero). See Lee, Kim, Lee and Shin, "A New Reference Cell for 1T-1MTJ MRAM," Journal of Semiconductor Technology and Science, Vol. 4, No. 2, June, 2004.

As described above, existing reference cell technologies may add up to the chip size, which will also increase power consumption of the chip due to higher reading currents required of the reference cells. In addition, reference cell placement requires the reference cell to be as close to the MRAM storage cell as possible for accurate reading. This makes the memory layout less flexible. These challenges become even more evident when considering the redundancies of reference cells. For example, if reference columns are used, and if one or more cells in a reference column are bad, that reference column will be replaced by a redundant column. This approach often requires more redundant reference cells in order to achieve better chip performance. However, this even increases the chip size more.

As described above, existing approaches are particularly challenging when applied to a low power and high-performance AI chip with embedded MRAM memory that has large memory bits but requires small chip size. Overcoming this challenge becomes critically important when designing an AI chip for mobile devices.

This document describes devices and methods that may address at least some of the above issues and/or other issues.

### SUMMARY

An integrated circuit may include an AI logic circuit, and an embedded one-time programmable (OTP) MRAM memory electrically coupled to the AI logic circuit. The embedded OTP MRAM memory may include: a plurality of storage cells, each storage cell including a one-time programmable MTJ bit cell; a reference resistor; and a memory-reading circuit to determine the state of each storage cell. The memory-reading circuit may include: a multiplexer configured to electrically couple each storage cell to a reference resistor; a source line selectively providing a first electrical signal to each storage cell to generate a first output signal; a driving circuit providing a second electrical signal to the reference resistor to generate a second output signal, and a comparator configured to compare the first output signal and the second output signal to generate an output signal indicating the state of each storage cell.

In some scenarios, each of the one or more reference resistors in the integrated circuit is a constant resistor, and the reference resistor may be formed in a bottom-electrode (BE) layer, a top-electrode (TE) layer, or a metal layer of a CMOS transistor. The OTP MRAM may be a spin orbit torque (SOT), spin transfer torque (STT), magnetoelectric RAM (MeRAM) / Voltage-controlled magnetic anisotropy (VCMA) MRAM or orthogonal spin transfer (OST) MRAM.

In some scenarios, the above described plurality of storage cells may be an array of OTP MRAM memory storage cells, which share a common single reference resistor. The OTP MRAM memory may include an additional array of storage cells electrically coupled to the single reference resistor. The OTP MRAM memory may include: an additional multiplexer configured to electrically couple each storage cell in the additional array of storage cells to the single reference resistor; an additional source line selectively providing a third electrical signal to each storage cell in the additional array of storage cells to generate a third output signal; and an additional comparator configured to compare the third output signal and the second output signal to generate an output signal that indicates a state of each storage cell in the additional array. In some scenarios, each storage cell in the embedded OTP MRAM memory has a read-margin window, and the reference resistor has a value that is in a mid-range of the read-margin window.

In some scenarios, above described integrated circuit may include one or more additional memories of different types from that of the OTP MRAM memory. Each of the one or more additional memories of different types may be a static random access memory (SRAM), STT-MRAM, MeRAM / VCMA MRAM, SOT MRAM, and/or OST MRAM.

In some scenarios, a method of reading above described embedded one-time programmable (OTP) MRAM memory in an artificial intelligence (AI) integrated circuit may include: coupling, by a multiplexer, each of a plurality of storage cells in the embedded OTP MRAM to a reference resistor, wherein each storage cell comprises a one-time programmable MTJ bit cell; providing, by a source line, a first electrical signal to each storage cell to generate a first output signal; providing, by a driving circuit, a second electrical signal to the reference resistor to generate a second output signal; and comparing the first output signal and the second output signal to generate an output signal that indicates a state of each storage cell.

### BRIEF DESCRIPTION OF THE DRAWINGS

FIGs. 1A and 1B show examples of an AI chip that contains various memory types.
FIGs. 2A and 2B show examples of an embedded OTP MRAM memory.
FIG. 3 shows a schematic diagram of an example of an integrated circuit having multiple arrays of storage cells and a reference resistor for reading data from the storage cells in multiple arrays.
FIG. 4 shows an example of a diagram of a memory-reading process according to some embodiments.

### DETAILED DESCRIPTION

It will be readily understood that the components of the embodiments as generally described herein and illustrated in the appended figures could be arranged and designed in a wide variety of different configurations. Thus, the following more detailed description of various embodiments, as represented in the figures, is not intended to limit the scope of the present disclosure, but is merely representative of various embodiments. While the various aspects of the embodiments are presented in drawings, the drawings are not necessarily drawn to scale unless specifically indicated.

The present invention may be embodied in other specific forms without departing from its spirit or essential characteristics. The described embodiments are to be considered in all respects only as illustrative and not restrictive. The scope of the invention is, therefore, indicated by the appended claims rather than by this detailed description. All changes which come within the meaning and range of equivalency of the claims are to be embraced within their scope.

References throughout this specification to features, advantages, or similar language do not imply that all of the features and advantages that may be realized with the present invention should be or are in any single embodiment of the invention. Rather, language referring to the features and advantages is understood to mean that a specific feature, advantage, or characteristic described in connection with an embodiment is included in at least one embodiment of the present invention. Thus, discussions of the features and advantages, and similar language, throughout the specification may, but do not necessarily, refer to the same embodiment.

Furthermore, the described features, advantages and characteristics of the invention may be combined in any suitable manner in one or more embodiments. One skilled in the relevant art will recognize, in light of the description herein, that the invention can be practiced without one or more of the specific features or advantages of a particular embodiment. In other instances, additional features and advantages may be recognized in certain embodiments that may not be present in all embodiments of the invention.

As used in this document, the singular form "a", "an", and "the" include plural references unless the context clearly dictates otherwise. Unless defined otherwise, all technical and scientific terms used herein have the same meanings as commonly understood by one of ordinary skill in the art. As used in this document, the term "comprising" means "including, but not limited to." Unless defined otherwise, all technical and scientific terms used in this document have the same meanings as commonly understood by one of ordinary skill in the art.

Each of the terms "artificial intelligence logic circuit" and "AI logic circuit" refers to a logic circuit that is configured to execute certain AI functions such as a neural network in AI or machine learning tasks. An AI logic circuit can be a processor. An AI logic circuit can also be a logic circuit that is controlled by an external processor and executes certain AI functions.

Each of the terms "integrated circuit," "semiconductor chip," "chip" and "semiconductor device" refers to an integrated circuit (IC) that contains electronic circuits on semiconductor materials, such as silicon, for performing certain functions. For example, an integrated circuit can be a microprocessor, a memory, a programmable array logic (PAL) device, an application-specific integrated circuit (ASIC) or others. An integrated circuit that contains an AI logic circuit is referred to as an AI integrated circuit or an AI chip.

The term "wafer level" for the purpose of programming a memory in an integrated circuit refers to programming the memory while the chip is still in wafer form. Wafer-level programming is generally performed at foundries at the time of manufacturing.

Each of the terms "chip packaging level" or "chip level" for the purpose of programming a memory in an integrated circuit (i.e., the semiconductor chip) refers to programming the semiconductor chip while the chip is already packaged. Chip-level programming can be performed at foundries or at a user site after the chip has been manufactured.

The term "electrically coupled" refers to establishing a current flow from an electrical component to another. The establishment of the current flow may be done via applying a voltage, a current or use of a switching device (e.g., a transistor) that is operable to turn on/off the current flow between components.

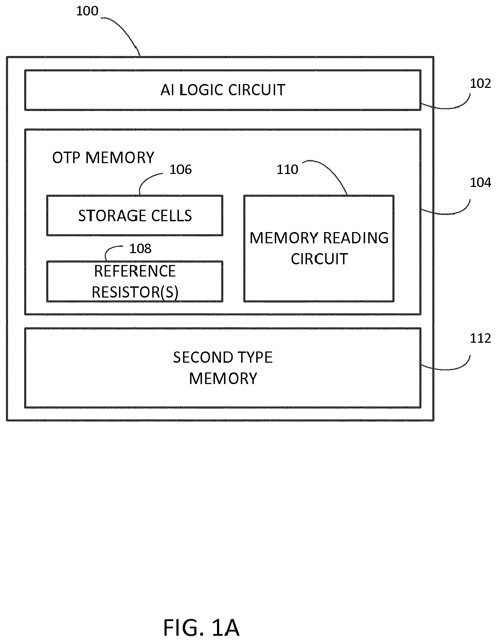

In FIG. 1A, an example of an AI chip having an OTP MRAM memory and a second type of memory is illustrated. AI chip **100** may include an AI logic circuit **102.** For example, the AI logic circuit **102** may include a cellular neural network (CNN) logic circuit that contains a convolutional neural network architecture for performing various AI tasks. The AI chip may include an OTP MRAM memory **104** which may be electrically coupled to the AI logic circuit **102.** The OTP MRAM memory may include multiple storage cells, each storage cell including a one-time programmable MTJ bit cell that has a state indicating a value of one or zero. The one-time programmable MTJ bit cell allows user to program its state only once. A user may program each storage cell to store a value of one or zero by setting the state of the storage cell once, after which the state of each storage cell becomes substantially permanent. Then the contents in the OTP MRAM memory are secure and unchangeable by any conventional means in programming an integrated circuit chip such as an ultraviolet (UV) erase, magnetic force, radiation, a power surge, or by other unforeseen security threats. This makes the OTP MRAM memory particularly suitable for storing data that does not require frequent changes in an AI chip.

For example, in performing an AI task, the OTP MRAM memory may store weights of a convolutional neural network and the AI logic circuit, such as the CNN logic circuit may retrieve the stored weights from the OTP MRAM memory **104.** A specific application such as face recognition requires a particular set of filter coefficients, which can be permanently written to the AI chip during fabrication. Alternatively, and/or additionally, for a specific application (e.g., security for certain application or user), certain data can be permanently written to the AI chip.

In some scenarios, OTP MRAM memory **104** may include one or more storage cells **106,** one or more reference resistors **108,** and a memory reading circuit **110,** which will be explained later in the document. The AI chip also may include a second type of memory **112** coexisting inside the chip. The second type of memory **112** may be a random access memory (RAM) to store programming instructions for the AI logic circuit or an external processor to perform various AI tasks, or to store intermediate results in performing the AI tasks. In some scenarios, the second type of memory **112** may include static random access memory (SRAM), STT-MRAM, MeRAM / VCMA MRAM, SOT MRAM, and/or OST MRAM.

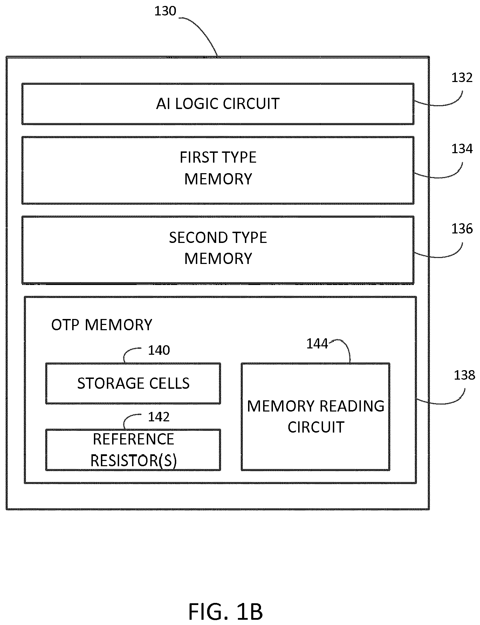

FIG. 1B illustrates another example of an AI chip **130,** which may include a similar structure as that of the AI chip **100** in FIG. 1A, except that it has a first type of memory **134,** a second type of memory **136,** and an OTP MRAM memory **138** which is electronically coupled to the AI logic circuit. The first type of memory **134,** the second type of memory **136** and the OTP MRAM memory **138** (i.e., a third type of memory) may co-exist inside the AI chip. The first and second types of memory **134, 136** may have similar types to those in the second type of memory **112** in the AI chip in FIG. 1A, and also may store programming instructions for performing various AI tasks or intermediate results in performing the AI tasks. Similar to the OTP MRAM memory **104** in FIG. 1A, in some scenarios, OTP MRAM memory **138** also may include one or more storage cells **140,** one or more reference resistors **142,** and a memory reading circuit **144,** which will be described in detail later in this document.

With reference to FIGs. 1A and 1B, each of the OTP MRAM storage cells **106, 140** can be set (i.e., programmed) to a permanent state in many stages, such as, at wafer level, chip-packaging level, or after soldering during fabrication of an AI chip. The OTP MRAM memory is a programmable resistive device, of which the resistance state (determined by the resistance value) may change after a means of programming that sets each storage cell to a state. For example, for an OTP MRAM memory storage cell that has an MTJ bit cell, setting the state of the MTJ bit cell may be done by an anti-fuse technique which creates a permanent conductive path in the MTJ bit cell to allow high current to flow through the OTP MRAM memory storage cell. In some scenarios, one anti-fuse technique may include breaking down the oxide barrier layer of the MTJ bit cell to induce a high current to flow through the MTJ bit cell. Breaking down the oxide barrier layer of an MTJ element may include a number of techniques, such as higher voltage, longer electrical current or smaller MTJ sizing as available in prior art.

In an OTP MRAM memory, the low resistance Rp of the MTJ bit cell becomes zero when the MTJ bit cell is broken down. This causes the read-margin window of the OTP MRAM memory to become Rp (i.e., zero) + Rc (i.e., the resistance of a transistor coupled to the MTJ bit cell)) - (Rap + Rc) = Rc - (Rap + Rc). In the example described earlier in this document, when Rp is about 1.6Kohms, Rap is about 3.2Kohms, and Rc is about 1.6Kohms, the read margin window for OTP MRAM memory is now 1.6Kohms - 4.8Kohms, which is much higher than 3.2Kohms - 4.8Kohms with the MRAM memory. Due to the increase of read-margin window in OTP MRAM memory, in some scenarios, the reading of the OTP MRAM memory storage cells may not need to use a typical reference cell but instead use a constant reference resistor having a constant resistance value. Further, a lower current or voltage may be applied in reading the memory. Device and method for reading OTP MRAM memory cells are further described in detail.

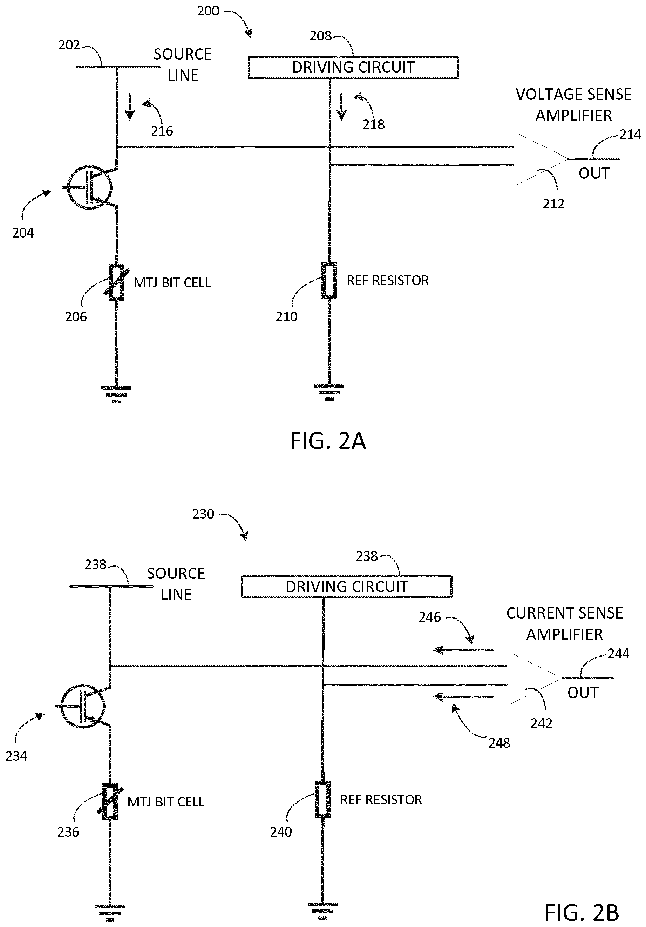

With reference to FIG. 2A, an embedded OTP MRAM memory that is electrically coupled to an AI logic circuit (e.g., **107** in FIG. 1A, **132** in FIG. 1B) inside the chip is shown. Embedded OTP MRAM memory **200** may include multiple storage cells, each storage cell including a one-time programmable MTJ bit cell **206.** The embedded OTP MRAM memory may also include a reference resistor **210,** which may be a constant reference resistor having a constant resistance value. The constant reference resistor is preferably formed in a non-MTJ bit cell, such as in a bottom-electrode (BE) layer, a top-electrode (TE) layer, or a metal layer of a CMOS transistor. The constant reference resistor may also be formed in an MTJ bit cell layer.

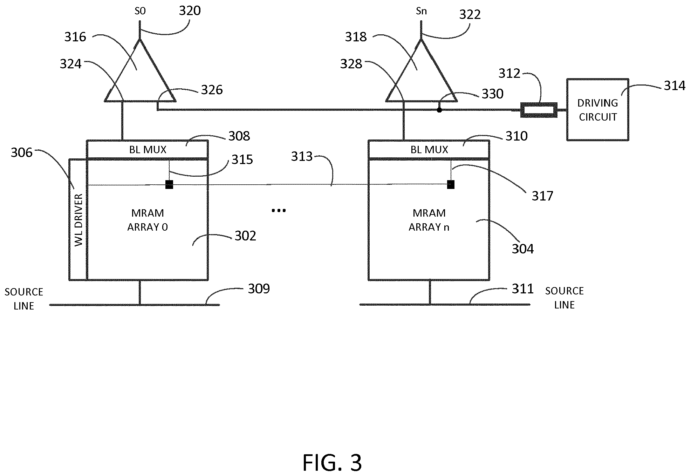

The embedded OTP MRAM memory **200** also may include a memory-reading circuit for reading the states of each storage cell contained in the memory. In some scenarios, the memory-reading circuit includes a multiplexer **204** for electrically coupling a storage cell **204** to the reference resistor **210.** For example, multiplexer **204** may operably switch on to electrically couple the storage cell **206** to reference resistor **210.** As illustrated in FIG. 2A, one storage cell may be electrically coupled to a unique reference resistor. Alternatively, multiple storage cells may be selectively and electrically coupled to a common reference resistor, as will be shown in FIG. 3.

Returning to FIG. 2A, in some scenarios, multiplexers **204** may be a transistor, such as a bipolar transistor, for which a gating signal may operably switch the transistor on or off. The embedded memory **200** also includes a source line **202** configured to selectively provide a first electrical signal to the storage cell **206** when the storage cell is coupled to the reference cell **210,** whereas the first electrical signal applied to the storage cell **206** generates a first output signal, such as a voltage. For example, source line **202** may provide a constant current **216** to the storage cell **206** to generate the first output signal, which is a voltage. The embedded memory **200** each also may include a driving circuit **208** that provides a second electrical signal to the reference resistor **210** to generate a second output signal. For example, the driving circuit **208** may provide a current **218** to the reference resistor **210** to generate the second output signal, which is a voltage.

The embedded memory **200** also may include a comparator **212** configured to compare the first output signal for the storage cell and the second output signal for the reference resistor to generate an output signal **214.** In some scenarios, the output signal **214** indicates the state of the selected storage cell. In some scenarios, the comparator is a sense amplifier commonly used in a memory circuit.

With reference to FIG. 2A, comparator **212** may be a voltage sensor amplifier. In this configuration, the source line **202** and the driving circuit **208** each provides a current **216, 218** to the selected storage cell **206** and the reference resistor **210,** respectively. The currents applied to the selected storage cell and the reference resistor generate respective output voltages across each component. In other words, the first output signal of each storage cell is the output voltage across the storage cell, and the second output signal of the reference resistor is the output voltage across the reference resistor. Because of the difference between the resistance value of the storage cell (e.g., the MTJ bit cell) and that of the reference resistor, the output voltages across the storage cell and the reference resistor are different. The voltage sense amplifier **212** receives the output voltages across the storage cell and the reference resistor and generates an output signal **214** based on the difference of the resistance value between the two, which indicates the state of the storage cell.

In determining the state of selected storage cell from the output signal of the comparator, in some scenarios, the output signal of the sense amplifier may be compared to a threshold. If the output signal exceeds the threshold, a state corresponding to a value of one in the selected storage cell may be determined. If the output signal is below the threshold, a state corresponding to a value of zero in the selected storage cell may be determined.

In FIG. 2B, an example of an embedded OTP MRAM memory **230** is shown to have a similar structure as that of the embedded OTP MRAM memory in FIG. 2A, except that comparator **244** is a current sense amplifier. In this configuration, source line **232** and driving circuit **238** each provides a respective constant voltage to the storage cell **236** and the reference cell **240,** and the provided voltages cause an output current **246, 248** in each component. In other words, the output signal for the storage cell and the reference cell is the current respectively flowing through each component. Due to the difference of resistance values of the storage cell and the reference resistor, the output currents in the two components are different. The current sense amplifier **242** receives these output currents and generates an output signal **244** based on the difference of the resistance value in a similar manner as the voltage sense amplifier **212** does. In some scenarios, source line **238** may provide a constant voltage, e.g., 1.2 volts, across the storage cell.

With reference to FIGs. 2A and 2B, in order for the sense amplifier to well sense the state of the storage cell, in some scenarios, the value of the reference resistor **210, 240** may be selected to be in the middle range of the read-margin window. The read-margin window depends at least on the resistance value of the storage cell and the current/voltage applied thereto. The higher ratio of high-resistance value to low-resistance value the storage cell has, the higher the read-margin window is. Similarly, the higher the driving current/voltage, the higher the read-margin window.

For example, in the above illustrated example, each MTJ bit cell in the storage cell of the embedded OTP MRAM memory has a high-resistance value Rap and a low-resistance value Rp, for example, at 3.2Kohms and 1.6Kohms, respectively. Each storage cell also includes a CMOS transistor electrically coupled to the MTJ bit cell in the storage cell, wherein the CMOS transistor has a resistance value Rc, for example, at 1.6Kohms. In such a case, the reference resistor may have a value that is in a mid-range of the read-margin window. In the above example, the read-margin window may be Rc to (Rc + Rap), i.e., 1.6Kohms - 4.8Kohms. The reference resistor may have a value in the mid-range of the window, e.g., (1.6Kohms + 4.8Kohms)/2 = 3.2Kohms. Due to the increased read-margin window associated with OTP MRAM memory as compared to the conventional MRAM memory, the source line and driving circuit may provide a lower current or voltage, which will result in decreased size of the chip and lower power consumption.

With further reference to FIG. 3, multiple memory arrays in an embedded OTP MRAM memory inside an AI chip are illustrated. An OTP MRAM may include multiple memory arrays **302, 304,** each memory array including multiple storage cells. For example, each memory array may include M rows and N columns of storage cells. Alternatively, each memory array may be made of a single row or single column of storage cells. Or, a memory array may be made of a single storage cell. One reference resistor **312** may be used for reading multiple MRAM arrays **302, 304,** which is explained in detail.

In case of an OTP MRAM memory array as shown in FIG. 3, the multiplexer may include: a word-line driver **306** for selecting a particular row **313** in the storage cell arrays **302, 304;** and a bit-line multiplexer **308, 310** each configured to select a particular column **315** or **317** in each respective storage cell arrays **302, 304.** In FIG. 3, the multiplexer, namely, word-line driver **306** and bit-line multiplexer **308, 310** are configured to selectively and electrically couple only one storage cell in the multiple MRAM arrays **302, 304** to the reference resistor **312** at a time. For example, the memory arrays **302, 304** may use a common word-line driver **306,** and each has a bit-line multiplexer **308, 310.** The word-line driver **306** may be configured to select a common row **313** between the two arrays **302, 304,** and only one of the bit-line multiplexers **308, 310** may be operable to select a column **315** or **317** in a respective array. Accordingly, the embedded OTP MRAM memory may include additional comparators, e.g., **318** corresponding to MRAM array **304,** in which the storage cell is selected.

The embedded memory may include a source line **309, 311** that provide a first electrical signal to the selected storage cell in each respective MRAM array to generate a first output signal. The embedded memory also may include a driving circuit **314** that provides a second electrical signal to the reference resistor **312** to generate a second output signal. The embedded memory also may include multiple comparators, such as **316, 318,** each configured to compare the first output signal and the second output signal for each respective MRAM array **302, 304.** The comparator **316, 318** each generates an output signal **320, 322** which indicates the state of the selected storage cell. Similar to the single storage cell in FIGs. 2A and 2B, the comparators **316, 318** each may be a sense amplifier commonly used in a memory circuit, such as a voltage sense amplifier or a current sense amplifier.

In the case of a voltage sense amplifier, similar to FIG. 2A, each of the first and second electrical signals is a current. For example, the source line **309, 311** may provide a current flow to the selected storage cell, and the first output signal may be a voltage across the storage cell. Similarly, the driving circuit **314** may also provide a current flowing through the reference resistor **312,** which generates an output voltage as the second output signal. The comparator **316,** such as a voltage sense amplifier, may receive the first and second output signals respectively at input **324, 326** and generate an output signal s0 at **320.** The output s0 indicates the state of the selected storage cell at row **313** and column **315,** e.g., either a value of zero or one.

The above example of OTP MRAM memory is described to have two arrays that have a common word-line driver for illustration purpose only. Other variations of the circuit layout may be possible. For example, the source line **309, 311** may share one common voltage line. Multiple memory arrays may not be required to share a common word-line driver. Each of the memory arrays may have its own bit-line multiplexer and word-line driver. Multiple memory arrays also may have a common bit-line multiplexer. Further, multiple memory arrays may not need to share a common reference resistor **312** as shown in FIG. 3. Instead, each of the multiple-memory arrays may have its separate reference resistor, or some memory arrays may share a common reference resistor, while other memory arrays may each have a separate reference resistor. Still further, each memory array may have its own comparator. Alternatively, and/or additionally, some memory arrays may have a common comparator.

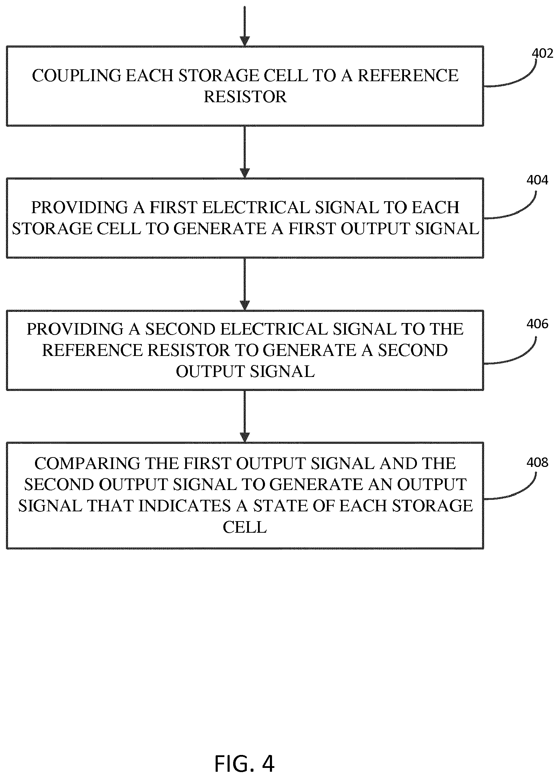

A process for memory reading in the above illustrated embedded OTP MRAM memory is now further described. With reference to FIG. 4, a method of reading an embedded one-time programmable (OTP) MRAM memory in an artificial intelligence (AI) integrated circuit may include: (1) coupling, by a multiplexer, each of a plurality of storage cells in the embedded OTP MRAM to a reference resistor **402,** wherein each storage cell comprises a one-time programmable MTJ bit cell; (2) providing, by a source line, a first electrical signal to each storage cell to generate a first output signal **404;** (3) providing, by a driving circuit, a second electrical signal to the reference resistor to generate a second output signal **406;** and (4) comparing the first output signal and the second output signal to generate an output signal that indicates a state of each storage cell **408.** In some scenarios, comparing the first output signal and the second output signal may be done using a sense amplifier.

The various structures and methods disclosed in this patent document provide advantages over the prior art, whether standalone or combined. The above illustrated embedded OTP MRAM memory and memory reading methods use one or more reference resistors, in lieu of conventional reference cells in existing MRAM memory. This may avoid excessive use of reference or memory cell data redundancy and decrease overhead capacities. The constant reference resistor may not be required to be placed near the storage cells or have a similar structure as that of the storage cells to maintain uniformity and accurate reading. Instead, the reference resistor may be flexibly placed anywhere in the layout, and the number of reference resistors may also be minimized. Due to increased read-margin window associated with OTP MRAM, a lower current/voltage is required to read the memory. These advantages make it possible to optimize the memory chip in size, power consumption and performance.

The advantages of smaller chip size and low-power consumption achieved from above described embodiments make the AI chip particularly suitable for many mobile and Internet-of-things (IoT) applications. For example, in an AI application, the OTP MRAM memory may store trained weights of a convolutional neural network (CNN) architecture, and the AI logic circuit in the AI chip may be configured to execute certain AI functions using one or more weights stored in the OTP MRAM memory. In some scenarios, for example, in a security application, the OTP MRAM memory may store registered human faces and/or features of the human faces, and a face recognition application may retrieve the features of registered human faces from the OTP MRAM memory while executing programming instructions to perform the face recognition task.

Other advantages can be apparent to those skilled in the art from the foregoing specification. For example, the above described various embodiments are illustrated for one-transistor-one-magnetic-tunnel-junction (1T-1MTJ), but can also be applicable for other variations, such as 2T-2MTJ and so on. The driving circuit for the reference resistor may provide a current signal, and the output signal at the input of the comparator may be a voltage signal. Alternatively, the driving circuit for the reference resistor may provide a voltage signal, and the output signal at the input of the comparator may be a current signal. Further, FIGs. 1A and 1B depict only examples of an AI chip that has an OTP MRAM memory and one or two RAM memories. Alternatively, as appreciated by one ordinarily skilled in the art, an AI chip may include additional RAM memories of different types, and the layout of different types of memories in the chip can vary.

Accordingly, it will be recognized by those skilled in the art that changes or modifications may be made to the above-described embodiments without departing from the broad inventive concepts of the invention. It should, therefore, be understood that this invention is not limited to the particular embodiments described herein, but is intended to include all changes, modifications, and all combinations of various embodiments that are within the scope and spirit of the invention as defined in the claims.

## Claims

1. An integrated circuit for artificial intelligence (AI) processing comprising:
an AI logic circuit; and
an embedded one-time programmable (OTP) MRAM memory electrically coupled to the AI logic circuit for storing AI model parameters, the embedded OTP MRAM memory comprising:
a plurality of storage cells, each storage cell comprising a one-time programmable MTJ bit cell for storing AI model parameters that do not frequently change, and
a reference resistor, and
a memory-reading circuit comprising:
a multiplexer configured to electrically couple each storage cell to the reference resistor,
a source line selectively providing a first electrical signal to each storage cell to generate a first output signal,
a driving circuit providing a second electrical signal to the reference resistor to generate a second output signal, and
a comparator configured to compare the first output signal and the second output signal to generate an output that indicates a state of each storage cell.

2. The integrated circuit of claim 1, wherein the OTP MRAM is a spin orbit torque (SOT), spin transfer torque (STT), magnetoelectric RAM (MeRAM) / Voltage-controlled magnetic anisotropy (VCMA) MRAM or orthogonal spin transfer (OST) MRAM.

3. The integrated circuit according to any previous claim, wherein the reference resistor is a constant resistor having a constant resistance value, and/or
wherein the reference resistor is formed in a bottom-electrode (BE) layer, a top-electrode (TE) layer, or a metal layer of a CMOS transistor.

4. The integrated circuit according to any previous claim,
wherein:
each of the first and second electrical signals is a current; and
each of the first and second output signals is a voltage;
and/or wherein:
the comparator is a sense amplifier.

5. The integrated circuit according to any previous claim, wherein the multiplexer of the embedded OTP MRAM memory is configured to electrically couple each storage cell in an array of storage cells to the reference resistor.

6. The integrated circuit of claim 5, wherein the embedded OTP MRAM memory further comprises:
an additional multiplexer configured to electrically couple each storage cell in an additional array of storage cells to the reference resistor;
an additional source line selectively providing a third electrical signal to each storage cell in the additional array of storage cells to generate a third output signal; and
an additional comparator configured to compare the third output signal and the second output signal to generate an output that indicates a state of each storage cell in the additional array of storage cells.

7. The integrated circuit according to any previous claim,
wherein:
each storage cell in the embedded OTP MRAM memory has a read-margin window; and
the reference resistor has a value that is in a mid-range of the read-margin window;
and/or wherein:
the plurality of storage cells in the embedded OTP MRAM store one or more weights of a convolutional neural network (CNN); and
the AI logic circuit is configured to execute certain AI functions using the one or more weights of the CNN.

8. A method of reading an embedded one-time programmable (OTP) MRAM memory for storing artificial intelligence (AI) model parameters in an AI integrated circuit, the method comprising:
coupling, by a multiplexer, each of a plurality of storage cells in the OTP MRAM to a reference resistor having a constant resistance value, wherein each storage cell comprises a one-time programmable MTJ bit cell for storing AI model parameters that do not need frequent change and wherein one-time programmable MTJ bit cell is embedded in the AI integrated circuit;
providing, by a source line, a first electrical signal to each storage cell to generate a first output signal;
providing, by a driving circuit, a second electrical signal to the reference resistor to generate a second output signal; and
comparing a first output signal and the second output signal to generate an output signal that indicates a state of each storage cell.

9. The method of claim 8,
wherein:
the reference resistor is formed in a bottom-electrode (BE) layer, a top-electrode (TE) layer, or a metal layer of a CMOS transistor;
and/or wherein:
each of the first and second electrical signals is a current; and
each of the first and second output signals is a voltage.

10. The method of claim 8 or claim 9, wherein comparing the first output signal and the second output signal uses a sense amplifier configured to receive input signals from the first output signal and the second output signal.

11. The method of claim 10, further comprising:
coupling, by an additional multiplexer, each of an additional plurality of storage cells in the embedded OTP MRAM to the reference resistor, wherein each of the additional plurality of storage cells comprises a one-time programmable MTJ bit cell;
providing, by an additional source line, a third electrical signal to each of the additional plurality of storage cells to generate a third output signal; and
comparing the third output signal and the second output signal to generate an output signal that indicates a state of each of the additional plurality of storage cells.

12. The method according to any of claims 8 to 11, wherein:
each storage cell in the embedded OTP MRAM memory has a read-margin window; and the reference resistor has a value that is in a mid-range of the read-margin window.

13. The method according to any of claims 8 to 12, further comprising:
storing in the plurality of storage cells in the embedded OTP MRAM one or more weights of a convolutional neural network (CNN); and
causing the AI logic circuit to execute certain AI functions using the one or more weights of the CNN.

14. An integrated circuit for artificial intelligence (AI) processing comprising:
an AI logic circuit;
an embedded one-time programmable (OTP) MRAM memory of a first type electrically coupled to the AI logic circuit fir storing AI model parameters, the embedded OTP MRAM memory comprising:
a plurality of storage cells, each storage cell comprising at least a one-time programmable MTJ bit cell for storing AI model parameters that do not need frequent change, and
a reference resistor, and
a memory-reading circuit comprising:
a multiplexer configured to electrically couple each storage cell to the reference resistors,
a source line selectively providing a first electrical signal to each storage cell to generate a first output signal,
a driving circuit providing a second electrical signal to the reference resistor to generate a second output signal, and
a comparator configured to compare the first output signal and the second output signal to generate an output signal that indicates a stage of each storage cell; and
one or more additional embedded RAM memories of types that are different from the first type.

15. The integrated circuit of claim 14,
wherein:
the embedded OTP MRAM memory of the first type is a spin orbit torque (SOT), spin transfer torque (STT), magnetoelectric RAM (MeRAM) / Voltage-controlled magnetic anisotropy (VCMA) MRAM or orthogonal spin transfer (OST) MRAM;
and/or wherein:
each of the one or more additional embedded RAM memories is a static random access memory (SRAM), spin orbit torque (SOT), spin transfer torque (STT), magnetoelectric RAM (MeRAM) / Voltage-controlled magnetic anisotropy (VCMA) MRAM or orthogonal spin transfer (OST) MRAM.
